Europäisches Patentamt

**European Patent Office**

Office européen des brevets

(11) Publication number: **0 039 175**
**A2**

# EUROPEAN PATENT APPLICATION

(21) Application number: **81301668.0**

(22) Date of filing: **15.04.81**

(51) Int. Cl.³: **H 01 R 23/68**

(30) Priority: **28.04.80 US 144706**

(43) Date of publication of application:
**04.11.81 Bulletin 81/44**

(84) Designated Contracting States:
**DE FR GB IT NL**

(71) Applicant: **AMP INCORPORATED**
**Eisenhower Boulevard**
**Harrisburg, Pennsylvania(US)**

(72) Inventor: **Andrews, Howard Wallace**
**828 East Chocolate Avenue**
**Hershey Pennsylvania 17033(US)**

(72) Inventor: **Cobaugh, Robert Franklin**
**Box 144A R.D. No. 2**
**Elizabethtown Pennsylvania 17022(US)**

(74) Representative: **Terrell, Thomas Gwyn et al,**
**20 Queensmere**
**Slough, Berkshire SL1 1YZ(GB)**

(54) Electrical connecting assembly for circuit cards.

(57) The assembly comprises circuit cards (14, 26 and 26') between which are insulating modules (30) having rows of terminals (32) extending through internally metalically plated holes (46 and 46') in the cards (14, 26 and 26'). For the conservation of space on the circuit boards (14, 26 and 26') the modules (30) are arranged in overlapping relationship, the terminals (32) of one row of terminals (32) of each module (30) extending into an opening (42) in the other module (30). The modules (30) are spaced back from the edges (50 and 50') of the cards (14, 26 and 26') so that these edges (50 and 50') can be inserted into circuit card edge connectors (not shown).

FIG.3

Electrical connecting assembly for circuit cards.

There is disclosed in the specification of Patent of Addition No. 69,606 to French Patent No. 1,097,940, an electrical connecting assembly comprising a first circuit card, a second circuit card arranged in face-to-face relationship with the first card, and a module disposed between the circuit cards, the module comprising an elongate housing made of electrically insulating material and having therein a row of spaced electrical terminals, end portions of which project from opposite sides of the housing transversely of the length thereof, the terminal end portions projecting from one side of the housing being received in holes in the first card and the terminal end portions projecting from the opposite side of the housing being received in holes in the second card to interconnect selected conductors on the cards.

In this known assembly (which dates from the year 1956), the projecting end portions of the terminals are soldered to the conductors of the cards. According to current practice, however, as exemplified, for example, by the disclosure of US-A-4,186,982, it is usual for holes in a circuit card to be metalically plated internally and for terminal end portions to be inserted into such holes to be provided with means for force fitting them into the holes, the inserted terminal end portions projecting beyond the opposite face of the card to that through which such end portions were inserted.

0039175
9393

Also, according to current practice, it is usual for circuit cards to be as densly packed with circuit components as may be practicable, with a view to economising in the space taken up by the circuits concerned.

The present invention proceeds from the realization that in the application of an assembly as defined in the first paragraph of the present specification to modern circuit design practice, it is necessary to provide for a substantially increased number of external connections to the card circuitry and at the same time to minimise the circuit card area taken up by the external connecting means.

According to the invention therefore, an electrical connecting assembly as defined in the first paragraph of the present specification is characterised by a second and similar module disposed on the opposite side of the first card to the first module and in overlapping, substantially parallel relationship with the first module, the terminal end portions projecting from the one side of the housing of the second module being received in further holes in the first card and the terminal end portions projecting from the opposite side of the housing of the second module being received in further holes in a third circuit card arranged in face-to-face relationship with the first and second cards, to interconnect selected conductors on the first and third cards; and in that the terminal end portions projecting from the one side of each housing each protrude through the holes of the first card, which holes are internally metalically plated, into an opening formed in the one side of the other housing.

The modules may have a plurality of rows of terminals and may be arranged in offset relationship transversely of their length and substantially parallel to the first card, to allow the terminal ends of a row of terminals of each module to extend beside the other module, and shielding plates connected to respective ones of the second and third cards may be interposed between the rows. The housings of the modules are conveniently moulded from glass filled resin, the terminals and the shielding plates being moulded thereinto.

The present state of the art is further exemplified by US-A-2,947,914 and US-A-4,054,345.

For a better understanding of the invention, an embodiment thereof will now be described by way of example with reference to the accompanying drawings in which:-

Figure 1 is a perspective view of a circuit card cage with part removed;

Figure 2 is an enlarged, partly diagrammatic, fragmentary perspective view showing details of an electrical connecting assembly of the card cage; and

Figure 3 is a view taken on the lines III - III of Figure 2, with parts omitted.

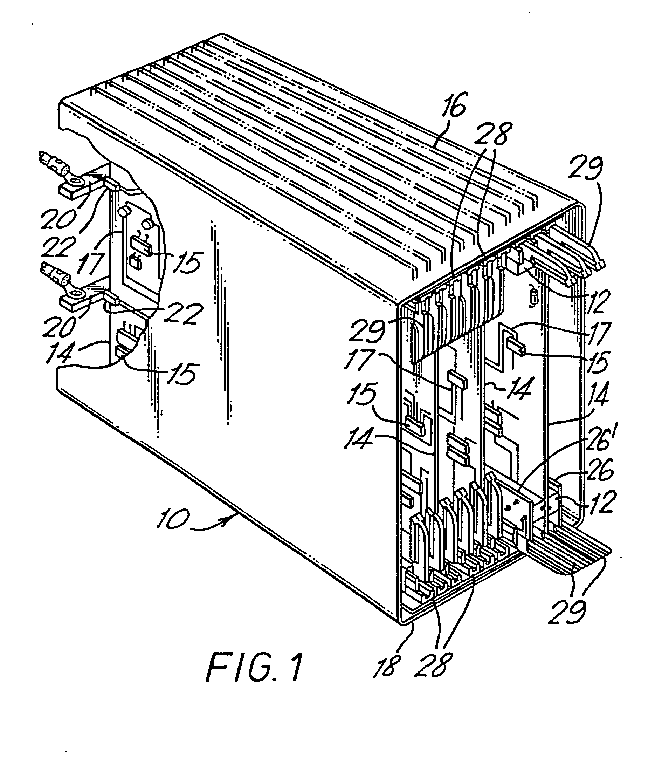

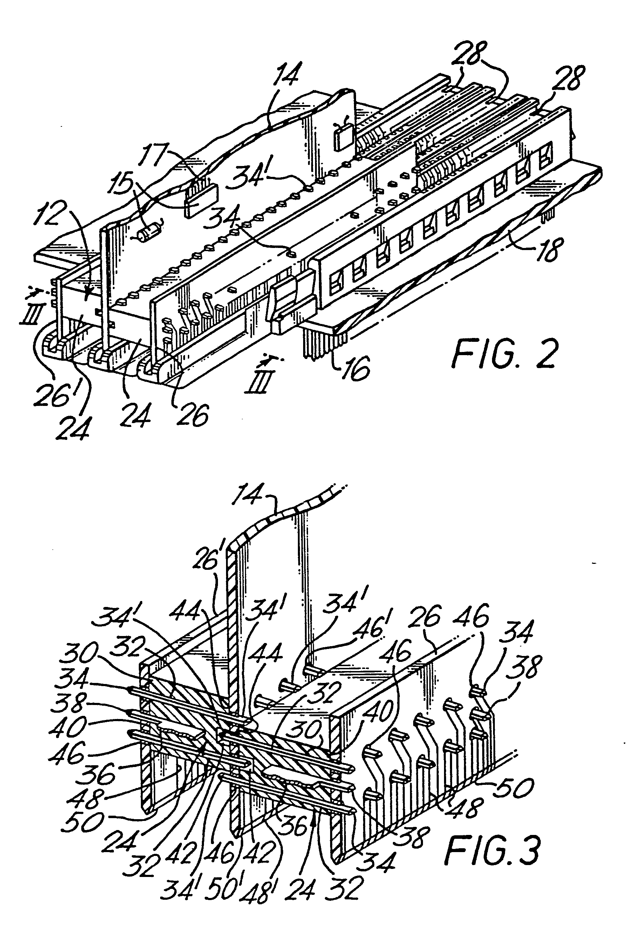

The circuit card cage, which is elongate and which is generally referenced 10 in Figure 1, comprises six electrical connecting assemblies 12 (only two of which are shown), which connect selected conductors of the circuits of three major circuit cards 14 to other circuits (not shown) via rows of connecting pins 16 (indicated only diagrammatically in Figure 1), projecting from zero insertion force circuit card edge connectors 28, through opposite walls 18 of the card cage. Each card 14 is densely packed with circuit components 15, a few of which are shown in Figures 1 and 2 and which are interconnected by means of signal conductors 17. The other circuits mentioned above may be on a mother board (not shown) into which the pins 16 have been inserted, or the pins 16 may, for example, be connected to the other circuits by means of wire wrap connections (not shown).

Power is supplied to the card cage 10 through bus bars 20 plugged into power modules 22 positioned on, and connected to the circuits of, each card 14. The bars 20, which extend across the rear (as seen in Figure 1) end of the cage 10 may be secured to walls thereof.

Each connecting assembly 12 comprises a pair of modules 24 on either side of a card 14, and two elongate, minor circuit cards 26 and 26', the cards being arranged in parallel face-to-face relationship.

As best seen in Figure 3, each module 24 comprises an elongate housing 30 in the form of a block of insulating material e.g. a glass filled synthetic resin, in which are embedded two parallel rows of rectilinear post terminals 32, preferably of phosphor bronze, each such row extending transversely of the length of the housing 30 and thus lengthwise of the cage 10. End portions 34 and 34' of the terminals 32 project laterally from each housing 30 on each of two opposite sides 40 and 44 thereof. A shielding plate 36 preferably of copper, also embedded in the housing 30, extends for the full length thereof between the two rows of terminals 32 and is spaced from the sides 40 and 44. Pins 38 formed integrally with the plate 32, project from the side 40 at intervals there along. A slot 42 formed in the side 44, is positioned midway between the two rows of terminals 32 and extends longitudinally of the housing 30.

The minor cards 26 and 26' are of substantially smaller height than the major cards 14.  Each card
26 and 26' has three rows of internally metalically
plated holes 46, conductors 48 connected to the plating
of the holes 46, extending to the adjacent edge 50
of each card 26 and 26'.  Each major card 14 has
internally metalically plated holes 46' the plating
of which is connected to conductors 48' on the card
14, which extend to the adjacent edge 50' of that
card.

Each assembly 12 is provided by inserting the
terminal end portions 34' projecting from the side
44 of two modules 24 through corresponding holes 46'
in a card 14 from opposite sides thereof, the modules
24 being in substantially parallel overlapping
relationship but being offset from one another
transversely of their length and parallel to the card
14 in such a way that the portions 34' of one row of
terminals 32 of each module 24 protrude through the
holes 46' and into the slot 42 of the other module
24 and the portions 34' of the other row of terminals
32 of each module 24 protrude through the holes 46'
and extend beside the housing 30 of the other module
24.  This arrangement is more economical of space on
the densely packed card 14 than would be the case if
the two modules 30 were spaced from one another to an
extent to avoid the necessity for the provision of
the slots 42 therein. A card 26 or 26' as the case
may be is then plugged onto the side 40 of each
module 24 so that each end portion 34 and pin 38
projecting from that side 40 is received in the
appropriate hole 46 of the card 26 or 26'

The cards 26 and 26' may, however, be assembled
to the module 24 before the modules 24 are assembled
to the card 14.

The end portions 34 and 34' may be formed with laterally resilient enlarged parts (not shown) according to US-A-4,186,982, adapted to be force fitted into the holes 46 and 46' to enhance the mechanical and electrical connections between the portions 34 and 34' and the plating of the holes 46 and 46'.

In the card cage 10, each of two opposite edge portions of each card 14 is incorporated into a connecting assembly 12 as shown in Figure 1, the edges 50 and 50' of the cards, which edges are parallel to one another and are disposed in the same plane, being received in the zero insertion force circuit card edge connectors 28, as shown in Figures 1 and 2. The cards are slid into the connectors 28 longitudinally thereof with the contacts (not shown) of the connectors 28 in an open, card-receiving, position, whereafter the contacts are closed about the margins of the cards, by depressing levers 29 of the connectors 28. Similar, but not identical, zero insertion force connectors are disclosed for example in US-A-4,133,592.

The connecting assemblies 12 have the advantage that the surface area of the cards 14 that is utilised for making connections to the circuits thereon is reduced to a minimum.

A connecting assembly 12 may be applied only to one edge portion of a card and may be used simply for connecting circuits on three cards, without the provision of card edge connectors or of a card cage.

The modules may have only one row of terminals, or more than two rows thereof and accordingly more than one slot 42.

Claims:

1. An electrical connecting assembly (12) comprising a first circuit card (14), a second circuit card (26) arranged in face-to-face relationship with the first card (14), and a module (24) disposed between the circuit cards (14 and 26), the module (24) comprising an elongate housing (30) made of electrically insulating material and having therein a row of spaced electrical terminals (32), end portions (34 and 34') of which project from opposite sides (40 and 44) of the housing (30) transversely of the length thereof, the terminal end portions (34') projecting from one side (44) of the housing (30) being received in holes (46') in the first card (14) and the terminal end portions (34) projecting from the opposite side (40) of the housing (30) being received in holes (46) in the second card (26) to interconnect selected conductors (48 and 48') on the cards (14 and 26); <u>characterised by</u> a second and similar module (24) disposed on the opposite side of the first card (14) to the first module (24) and in overlapping, substantially parallel relationship with the first module (24), the terminal end portions (34') projecting from the one side (44) of the housing (30) of the second module (24) being received in further holes (46') in the first card (14) and the terminal end portions (34) projecting from the opposite side (40) of the housing (30) of the second module (24) being received in further holes (46) in a third circuit card (26') arranged in face-to-face relationship with the first and second cards (14 and 26), to interconnect selected conductors (48 and 48') on the first (14) and third (26') cards; and in that the terminal end portions (34') projecting from the one side (44) of each housing (30) each protrude through the holes (46') of the first card (14), which holes (46') are internally metalically plated, into an opening (42) formed in the one side (44) of the other housing (30).

2. A connecting assembly according to Claim 1, characterised in that the modules (24) are arranged in offset relationship transversely of their length and substantially parallel to the first card (14), each module (24) having a plurality of superposed, spaced rows of terminals (32), the terminal end portions (34') of one of the rows, which portions (34) project from the one side (44) of the housing (30) of each module (24), protruding through the holes (46') of the first card (14) and extending beside the housing (30) of the other module (24).

3. A connecting assembly according to Claim 2, characterised in that each module (24) has, embedded in the housing (30) thereof, a shielding plate (36) extending parallel to the rows of terminals (32) of the module (24) and being disposed between two such rows of terminals (32), a pin (38) projecting from the other side (40) of the housing (30) of each module (24) extending into a hole (46) in the associated second or third card (26 or 26').

4. A connecting assembly according to Claim 1, 2 or 3, characterised in that each card (14, 26 and 26') has a free edge (50 or 50') to which the conductors on the card (14, 26 or 26') extend, for insertion in a printed circuit edge connector (28), the free edges (50 and 50') of the cards (14, 26 or 26') being parallel to one another and being disposed in the same plane.

5. A connecting assembly according to Claim 1, 2 or 3, characterised in that each module (30) extends parallel to, and is spaced from, the adjacent edges (50 and 50') of the circuit cards (14 and 26, or 14'

0039175

9393

and 26') between which the module (30) is disposed, each such edge (50 and 50') being received in a circuit card edge connector (28).

6. A connecting assembly according to any one of the preceding claims, characterised in that each housing (30) consists of a block of glass filled resin in which the terminals (32), which are in the form of rectilinear posts, are embedded.

FIG.1

FIG. 2

FIG.3